Europäisches Patentamt

European Patent Office

Office européen des brevets

(11) Veröffentlichungsnummer: **0 386 322**
**A1**

## (12) EUROPÄISCHE PATENTANMELDUNG

(21) Anmeldenummer: **89121407.4**

(22) Anmeldetag: **18.11.89**

(51) Int. Cl.5: **H03L 1/02**

(30) Priorität: **04.03.89 DE 3906999**

(43) Veröffentlichungstag der Anmeldung:
**12.09.90 Patentblatt 90/37**

(84) Benannte Vertragsstaaten:
**CH DE GB LI**

(71) Anmelder: **ROBERT BOSCH GMBH**
**Postfach 10 60 50**
**D-7000 Stuttgart 10(DE)**

(72) Erfinder: **Gubela, Peter**
**Anhaltiner Strasse 3**
**D-1000 Berlin 37(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**D-1000 Berlin 33(DE)**

(54) Schaltungsanordnung zur Kompensation der temperaturbedingten Frequenzänderung eines Quarzoszillators.

(57) Schaltungsanordnung zur Kompensation der temperaturbedingten Frequenzänderung eines Quarzoszillators, enthaltend einen mit dem Schwingquarz thermisch gekoppelten Temperaturaufnehmer, einer diesem nachgeschalteten Schaltung zur Nachbildung der Frequenz-Temperatur-Kennlinie des Schwingquarzes und einer Schaltungsverbindung vom Ausgang dieser Schaltung zu einem dessen Frequenz beeinflussenden Eingang des Quarzoszillators, wobei die Schaltung (5) zur Nachbildung der Frequenz-Temperatur-Kennlinie aus einer ersten Baugruppe (7) zur Nachbildung des linearen Anteils der Kennlinie, einer zweiten Baugruppe (8) zur Nachbildung des nichtlinearen Anteils der Kennlinie und einer dritten Baugruppe (9) zur Überlagerung der beiden Anteile besteht.

Fig. 1

EP 0 386 322 A1

# Schaltungsanordnung zur Kompensation der temperaturbedingten Frequenzänderung eines Quarzoszillators

Die Erfindung betrifft eine Schaltungsanordnung zur Temperaturgangkompensation der Frequenz eines Quarzoszillators.

Verschiedene Anwendungen von Quarzoszillatoren erfordern in weiten Temperaturbereichen eine Frequenzkonstanz, die die natürliche um das 10- bis 20fache übertrifft. Insbesondere der steigende Bedarf von Kanälen in der Funktechnik hat zu einer Reduzierung der Kanalabstände und damit zu erhöhten Anforderungen an die Frequenzkonstanz der Sender- und Empfängerquarze geführt.

Prinzipiell läßt sich dieses Ziel durch thermostatisches Konstanthalten der Umgebungstemperatur des Schwingquarzes erreichen. Damit sind jedoch wesentliche Nachteile und Probleme, vor allem ein hoher Energieverbrauch, großes Volumen, hoher Preis und eine nicht sofortige Betriebsbereitschaft nach dem Einschalten des Thermostaten verbunden.

Eine andere Möglichkeit, die Frequenz eines Quarzoszillators konstant zu halten, besteht darin, den temperaturbedingten Frequenzgang des Oszillators mittels temperaturabhängiger Stellglieder zu kompensieren. Die folgenden Varianten sind auf den Seiten 145 bis 149 der Veröffentlichung "Schwingquarze, Tagungsdokumentation des Quarz-Symposiums '85", Vistas-Verlag, Berlin 1985 beschrieben.

Ein grober Abgleich auf die Nennfrequenz ist durch einen temperaturabhängigen Kondensator, einer sogenannten Ziehkapazität, in Reihe mit dem Quarz erreichbar. Mit dieser Methode läßt sich jedoch nur der in erster Näherung lineare Bereich der Frequenz-Temperatur-Kennlinie kompensieren. Da der Kennlinienverlauf aber nichtlinear ist, erstreckt sich der annähernd lineare Teil der Kennlinie nur über einen schmalen Temperaturbereich. Außerdem besteht eine Abhängigkeit des Kurvenverlaufes vom jeweiligen Schnittwinkel des Schwingquarzes, so daß der Temperaturkoeffizient des Kondensators dem Schnittwinkel angepaßt sein muß.

Bekannt ist weiterhin die Verwendung einer Kapazitätsdiode als Stellglied und eines Thermistor(en)-Netzwerkes zur Erzeugung der erforderlichen Regelspannung. Diese Schaltung ermöglicht eine weitgehende Anpassung an den nichtlinearen Kennlinienverlauf, allerdings auch nur im Bereich zwischen den Wendepunkten der Kennlinie. Das bedeutet zwangsläufig, daß der Schnittwinkel des Quarzes so liegen muß, daß im Arbeitstemperaturbereich keine Wendepunkte liegen.

Kompensationsspannungsverläufe mit Wendepunkten lassen sich nur durch komplexere Netzwerkschaltungen mit Thermistoren im Längs- und Querzweig erzielen. Das hat jedoch nut dann einen Sinn, wenn der zu dem simulierten Kurvenverlauf gehörende Quarzschnittwinkel genau eingehalten wird, was aufgrund hoher Fertigungstoleranzen nur durch das Aussortieren geeigneter Quarze möglich ist. Bei Verwendung eines anderen Quarzschnittwinkels ist das komplexe Netzwerk jeweils neu zu dimensionieren und muß entsprechend verändert werden.

Neben dieser indirekten Kompensationsmethode, bei der ein Thermistor-Widerstands-Netzwerk über eine Spannung an einer Kapazitätsdiode die Frequenz ändert, ist auch eine direkte Kompensationsmethode bekannt, bei der eine Thermistor-Kapazitätskombination direkt auf den Schwingkreis einwirkt. Diese Methode hat den Vorteil, daß sie keine stabilisierte Netzwerkspannungsversorgung und keine Kapazitätsdiode benötigt, womit eine Platzersparnis und eine Reduzierung der Erforderlichen Betriebsspannung verbunden ist.

Alle vorstehend beschriebenen Schaltungsvarianten weisen den Nachteil auf, daß ihre Wirksamkeit stark von der Einhaltung eines bestimmten Quarzschnittwinkels abhängig ist. Der größte Teil der für die - jeweils recht komplexe - Schaltung verwendeten Bauelemente muß bereits bei geringfügigen Schnittwinkeländerungen umdimensioniert werden, was zu einer großen Anzahl von Varianten führt.

Eine Methode, die diesen Nachteil nicht besitzt, ist die digitale Temperaturkompensation. Hierbei wird das analoge Signal des Temperaturfühlers durch einen A/D-Wandler in eine digitale Information umgewandelt und ruft aus einem Speicher den zur Frequenzkompensation notwendigen Spannungswert in digitaler Form ab. Dieser digitale Wert wird nun mittels eines D/A-Wandlers in eine analoge Kompensationsspannung umgewandelt und bewirkt eine Korrektur der temperaturbedingten Frequenzabweichung vom Sollwert. Diese digitale Kompensationsmethode hat sich aber wegen ihrer Nachteile in bezug auf Kosten, Platz- und Energiebedarf bisher nicht durchsetzen können.

Der Erfindung liegt die Aufgabe zugrunde, eine Schaltungsanordnung zur Temperaturgangkompensation der Frequenz eines Quarzoszillators anzugeben, die auf einfache Weise an alle Quarzschnittwinkel anpaßbar ist, so daß die Fertigung von Quarzoszillatoren aufweisenden elektrischen Geräten auch in größeren Stückzahlen ohne spezielle Anpassung an unterschiedliche Quarzeigenschaften durch Schaltungsvarianten ermöglicht wird.

Diese Aufgabe wird bei einer Schaltungsanordnung gemäß dem Oberbegriff des Anspruchs 1 durch die im kennzeichnenden Teil dieses Anspruchs angegebenen Merkmale gelöst.

Die Erfindung beruht auf der Erkenntnis, daß sich die Frequenz-Temperatur-Charakteristik eines Schwingquarzes auf die Überlagerung eines linearen Anteils und eines kubischen Anteils in der Form

$$\Delta f/f = A_1 \, \Delta\phi \cdot \Delta T + A_3 \cdot \Delta^3$$

mit:

der relativen Frequenzänderung $\Delta f/f$,

der Temperaturdifferenz $\Delta T$ bis zum Wendepunkt der Kurve,

der Winkeldifferenz $\Delta\phi$ bis zum sogenannten Nullwinkel $\phi_0$ des Quarzschnittwinkels, bei dem die TK-Kurve eine horizontale Wendetangente hat ($A_1$ und $A_2$ sind Materialkonstanten),

zurückführen läßt, wobei lediglich der lineare Anteil

$$A_1 \cdot \Delta\phi \cdot \Delta T$$

eine Quarzschnittwinkelabhängigkeit aufweist, dessen Steigung von der Schnittwinkeldifferenz bestimmt wird. Die kubische Parabel

$$A_3 \cdot \Delta T^3$$

ist dagegen unabhängig vom Quarzschnittwinkel.

Zur Kompensation der Frequenz-Temperatur-Kennlinie sind nun separate Baugruppen zur Nachbildung einerseits des linearen Anteils der Kennlinie und andererseits des nichtlinearen Anteils der Kennlinie sowie eine dritte Baugruppe zur Überlagerung der beiden Anteile vorgesehen.

Der mit der Erfindung erzielbare wesentliche Vorteil besteht darin, daß der nichtlineare Anteil der Schaltung für nur einen definierten sogenannten Nullwinkel des Quarzschnittwinkels abgeglichen zu werden braucht und der gefundene Abgleich auch für alle anderen Schnittwinkel unverändert beibehalten werden kann. Die spezielle Anpassung an den tatsächlich vorhandenen Schnittwinkel erfolgt mittels eines Gewichtungsfaktors durch Veränderung des linea ren Anteils über ein entsprechendes Stellglied. Dieser kann in der Regel durch die Anpassung eines einzigen Widerstandes (oder eines entsprechenden eine lineare Charakteristik aufweisenden Bauelementes) oder aber durch den Abruf aus einem digitalen Speicher festgelegt werden. Dadurch erübrigt sich die bisher erforderliche große Variantenvielfalt und die Kompensationsschaltung kann in großen Stückzahlen gebaut werden. Auch ein späterer Austausch des Quarzes ist mit geringem Aufwand möglich.

Entsprechend einer vorteilhaften Weiterbildung der Erfindung werden die Gewichtungsfaktoren zur Kompensation der Abhängigkeit des linearen Anteils der Kennlinie vom Quarzschnittwinkel digital gespeichert und mittels eines multiplizierenden D/A-Wandlers mit einem, einem Nullwinkel des Schwingquarzes entsprechenden linearen Anteil verknüpft.

Zur Summation der beiden Anteile dient vorzugsweise eine Umkehrverstärkerschaltung mit einem Operationsverstärker.

Vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

Figur 1 ein Blockschaltbild eines Ausführungsbeispiels des erfindungsgemäßen Steuerkreises,

Figur 2 eine Ausführungsform einer Summationsschaltung als Detail der Schaltung gemäß Figur 1,

Figur 3 eine weitere Ausführungsform einer Summationsschaltung gemäß Figur 1 und

Figur 4 eine Prinzipdarstellung der Verknüpfung des linearen Anteils mit einem digital gespeicherten Gewichtungsfaktor.

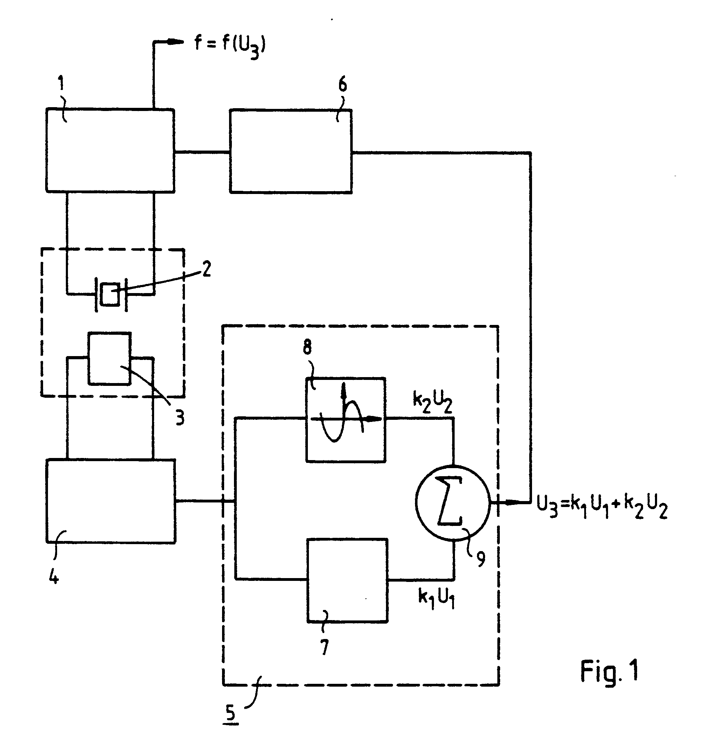

Das in Figur 1 dargestellte Blockschaltbild zeigt eine Schaltung zur Kompensation der temperaturbedingten Frequenzänderung eines Quarzoszillators 1, bestehend aus einem mit einem Schwingquarz 2 thermisch gekoppelten Temperaturaufnehmer 3, einem nachgeordneten Wandler 4, der die sich mit der Temperatur ändernde physikalische Größe in einen entsprechenden Spannungswert umsetzt. Die Wandlerkonstante $\alpha$ ist in Volt/ kelvin festgelegt. Eine daran anschließende Schaltungsbaugruppe 5 dient zur Nachbildung der Frequenz-Temperatur-Kennlinie des Schwingquarzes 2 in Spannungswerten. Ein Stellglied 6, dessen Eingang mit dem Ausgang der Baugruppe 5 verbunden ist, dient zur Spannungssteuerung des den Schwingquarz 2 enthaltenden Quarzoszillators 1 zur Veränderung der Schwingfrequenz. Diese ist mit der angelegten Spannung linear veränderlich.

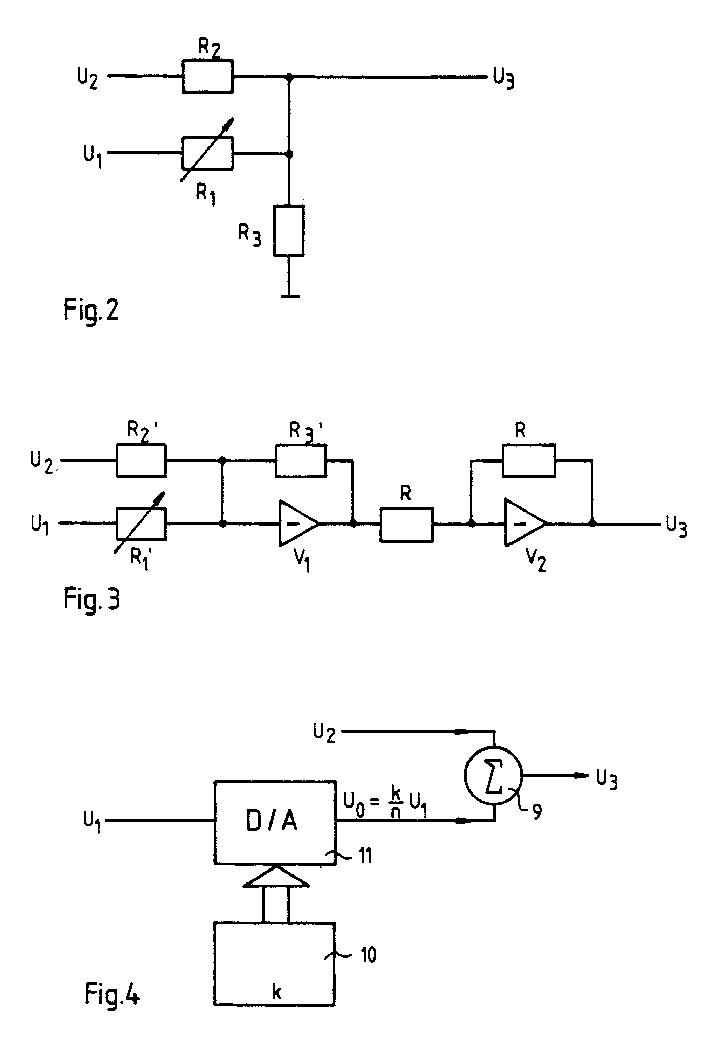

Der Schaltungsteil 5 zur Nachbildung der Frequenz-Temperatur-Kennlinie des Schwingquarzes 2 besteht dabei zunächst aus einer Baugruppe 7 zur Nachbildung des linearen Anteils der Kennlinie, wie sie weiter unten näher beschrieben ist. Eine weitere Baugruppe 8 zur Nachbildung des nichtlinearen Anteils der Kennlinie des Quarzes besteht aus einer bekannten Kompensationsschaltung für einen vorgegebenen Quarzschnittwinkel. Eine Summationsschaltung 9 zur Summation der beiden Anteile unter Variation der zu summierenden Anteile ist in den Figuren 2 bis 4 wiedergegeben.

Die Figuren 2 und 3 zeigen Schaltungen zur Realisierung der Summationsschaltung 9. Dabei bilden $U_1$ und $U_2$ die mit Hilfe des Temperatur-Spannungs-Wandlers 4 in Spannungswerte transponierten Ausgangssignale. Die Summation der Ausgangssignale $U_1$ und $U_2$ erfolgt unter Berücksichtigung der den Gewichtungsfaktor charakterisierenden Eingangsgewichtungsfaktoren $k_1$ und $k_2$.

Für die einfachste, in Figur 2 dargestellte, als Widerstandsnetzwerk ausgebildete Summationsschaltung gilt bei $R_1$, $R_2 \gg R_3$:

$k_1 = R_3/R_1$ und $k_2 = R_3/R_2$.

Der Widerstand $R_3$ bildet dabei den gemeinsamen Fußpunktwiderstand zweier mit $R_3$ jeweils einen Spannungsteiler bildenden Widerstände $R_1$ und $R_2$. $R_1$ ist dabei dem linearen Anteil zugeordnet und veränderlich.

Zur Anpassung der Schaltung an unterschiedliche Quarzschnittwinkel ist also lediglich eine entsprechende Anpassung des den linearen Anteil bestimmenden Widerstands $R_1$ notwendig. Mit $R_2$ kann eine Anpassung der Steigung des nichtlinearen Glieds vorgenommen werden. Dieser Widerstand braucht nach entsprechender Dimensionierung auch nach einem Quarzaustausch nicht verändert zu werden.

Bei der in Figur 3 gezeigten Schaltung ist die Baugruppe zur Summation der beiden Anteile als Umkehrverstärkerschaltung mit dem Operationsverstärker $V_1$ aufgebaut. Für die Eingangsgewichtungsfaktoren gilt wiederum: $k_1 = R_3/R_1{}'$ und $k_2 = R_3/R_2{}'$, wobei die Widerstände $R_1{}'$ und $R_2{}'$ mit dem invertierenden Eingang des Operationsverstärkers verbunden sind. Bei $R_3{}'$ handelt es sich um den Rückkopplungswiderstand der Operationsverstärkerschaltung.

Die Berücksichtigung von Eingangsgewichtungsfaktoren $k_1$ und $k_2$ bei der summationsschaltung erübrigt sich, wenn -wie bei dem in Figur 4 dargestellten Ausführungsbeispiel - ein Gewichtungsfaktor k bereits bei der Bildung des den linearen Anteil der Temperatur-Frequenz-Kennlinie des Schwingquarzes nachbildenden Ausgangssignales $U_0$ einbezogen wird.

Dazu wird ein multiplizierender Digital-Analog-Wandler 11 benutzt, dessen linearer Übertragungsfaktor durch in einem Speicher 10 festgehaltene Digitalwerte veränderbar ist.

Das ist beispielsweise, wie in Figur 4 gezeigt, dadurch möglich, daß eine große Anzahl von Gewichtungsfaktoren k digital gespeichert und mittels - nicht dargestellter - diesen Speicher adressierender Schaltmittel auswählbar ist.

Dabei gilt:

$U_0 = U_1 \cdot k/n$

mit

$0 \leq k \leq n$ (k ganzzahlig);

wobei n die Stufenzahl ist.

Für die in Bit benötigte Speicherkapazität m gilt:

$m = \ln n/\ln 2$.

Folglich beträgt die Speicherkapazität bei n = 256 Stufen 8 Bit.

Mit den dargestellten Schaltmitteln wird durch Variation des linearen Anteils der Kompensationsgröße eine Anpassung an den jeweiligen in der Oszillatorschaltung benutzten Quarz in Abhängigkeit von dessen Schnittrichtung vorgenommen. Die exakte Größe des linearen Anteils läßt sich während der Quarzfertigung aus den Daten der Temperaturgangmessung automatisch ermitteln und in geeigneter Weise -z.B. kodiert - auf dem Quarzgehäuse kennzeichnen. Dieser Kennzeichnung ist dann jeweils ein einzustellender Trimmwiderstandswert, ein einzulötender Festwiderstand oder ein zu speichernder Zahlenwert zugeordnet, so daß lediglich in bekannter Weise ein einmaliger Abgleich bei Herstellung des betreffenden Geräts oder nach einem Quarzwechsel vorgenommen werden muß. Diese Handhabung kann gegebenenfalls auch von einem Nichtfachmann ausgeführt werden. Der nichtlineare Anteil bleibt hingegen unveränderlich und wird einmalig für eine Geräteserie festgelegt.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch machen.

## Ansprüche

1. Schaltungsanordnung zur Kompensation der temperaturbedingten Frequenzänderung eines Quarzoszillators, enthaltend einen mit dem Schwingquarz (2) thermisch gekoppelten Temperaturaufnehmer (3), einer diesem nachgeschalteten Schaltung zur Nachbildung der Frequenz-Temperatur-Kennlinie des Schwingquarzes und einer Schaltungsverbindung vom Ausgang dieser Schaltung zu einem dessen Frequenz beeinflussenden Eingang des Quarzoszillators, **dadurch gekennzeichnet,** daß die Schaltung (5) zur Nachbildung der Frequenz-Temperatur-Kennlinie aus einer ersten Baugruppe (7) zur Nachbildung des linearen Anteils der Kennlinie, einer zweiten Baugruppe (8) zur Nachbildung des nichtlinearen Anteils der Kennlinie und einer dritten Baugruppe (9) zur Überlagerung der beiden Anteile besteht.

2. Schaltungsanordnung nach Anspruch 1, **dadurch gekennzeichnet,** daß die Überlagerungsschaltung (9) als Summierschaltung aufgebaut ist.

3. Schaltungsanordnung nach einem der vorangehenden Ansprüche, **dadurch gekennzeichnet,** daß ein Verstellelement zur Variation des linearen Anteils vorgesehen ist.

4. Schaltungsanordnung nach Anspruch 3, **dadurch gekennzeichnet,** daß als Verstellelement ein Speicher (10) für Gewichtungsfaktoren (k) vorgesehen ist und daß dem Speicher ein digital programmierbarer, insbesondere multiplizierender, D/A-Wandler (11) nachgeschaltet ist, dessen lineare Abhängigkeit des Ausgangs- vom Eingangssi-

gnal durch Adressierung eines entsprechenden im Speicher enthaltenen Gewichtungsfaktors veränderlich ist

5. Schaltungsanordnung nach Anspruch 3, **dadurch gekennzeichnet,** daß als Verstellelement ein veränderlicher Widerstand ($R_1$, $R_1'$) vorgesehen ist.

6. Schaltungsanordnung nach einem der vorangehenden Ansprüche, **dadurchgekennzeichnet,** daß die Überlagerungsschaltung als Operationsverstärkerschaltung ($V_1$) aufgebaut ist.

Fig. 1

Fig. 2

Fig. 3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 821 665 (J.S. IRWIN et al.) <br> * Spalte 1, Zeile 49 - Spalte 5, Zeile 51; Figuren 1-5 * <br> --- | 1-3,5,6 | H 03 L 1/02 |
| X | GB-A-2 038 125 (NIPPON ELECTRIC) <br> * Seite 1, Zeile 55 - Seite 4, Zeile 39; Figuren 1-5 * <br> --- | 1-3,5,6 | |
| A,D | WEINGÄRTNER et al.: "Schwingquarze ein unverzichtbares Bauelement in der Elektronik, QUARTZ-SYMPOSIUM '85", 1985, Seiten 136-153, Vistas Verlag, Berlin, DE <br> * Seite 148, Zeilen 5-15; Fig. * <br> ----- | 1,4 | |
| | | | **RECHERCHIERTE SACHGEBIETE (Int. Cl.5)** <br><br> H 03 L |

Der vorliegende Recherchenbericht wurde für alle Patentansprüche erstellt

| Recherchenort | Abschlußdatum der Recherche | Prüfer |
|---|---|---|
| DEN HAAG | 29-05-1990 | DHONDT I.E.E. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument